Europäisches Patentamt

European Patent Office

Office européen des brevets

(11) Veröffentlichungsnummer: **0 350 648**
**A2**

## EUROPÄISCHE PATENTANMELDUNG

(21) Anmeldenummer: 89110928.2

(22) Anmeldetag: 16.06.89

(51) Int. Cl.⁴: **C23C 18/38** , **C25D 3/38**

(30) Priorität: 13.07.88 DE 3824249

(43) Veröffentlichungstag der Anmeldung:
17.01.90 Patentblatt 90/03

(84) Benannte Vertragsstaaten:
**BE CH DE ES FR GB IT LI LU NL SE**

(71) Anmelder: **SCHERING AKTIENGESELLSCHAFT**
**Berlin und Bergkamen**
**Müllerstrasse 170/178 Postfach 65 03 11**
**D-1000 Berlin 65(DE)**

(72) Erfinder: **Tenbrink, Detlef**
**Hohoffstrasse 23**
**D-4750 Paderborn(DE)**
Erfinder: **Bock, Martin, Dr.**
**Senheimer Strasse 19**
**D-1000 Berlin 28(DE)**
Erfinder: **Heymann, Kurt, Dr.**
**Reichsstrasse 85**
**D-1000 Berlin 19(DE)**
Erfinder: **Rimkus, Martin**
**Winterfeldtstrasse 4**
**D-1000 Berlin 30(DE)**

(54) **Verfahren zur Herstellung hochtemperaturbeständiger Kupferbeschichtungen auf anorganischen Dielektrika.**

(57) Die Erfindung betrifft ein Verfahren zur Herstellung hochtemperaturbeständiger Kupferbeschichtungen auf anorganischen Dielektrika, vorzugsweise auf Keramik-und Emaillesubstraten, durch chemische und galvanische Metallabscheidung, gekennzeichnet durch folgende Verfahrensschritte:

- Abscheiden einer chemischen Kupferschicht in einer Schichtdicke von mindestens 3 $\mu$m
- Erhitzen der chemischen Kupferschicht auf Temperaturen>100° C, vorzugsweise auf 200 bis 450° C
- Mechanische Behandlung der chemischen Kupferschicht vorzugsweise durch Verdichtung der Oberfläche, insbesondere durch Bürsten und Polieren
- Abscheiden einer galvanischen Kupferschicht in einer Schichtdicke von mindestens 3 $\mu$m, vorzugsweise von 40 bis 100 $\mu$m.

# VERFAHREN ZUR HERSTELLUNG HOCHTEMPERATURBESTÄNDIGER KUPFERBESCHICHTUNGEN AUF ANORGANISCHEN DIELEKTRIKA

Die Erfindung betrifft ein Verfahren zur Herstellung hochtemperaturbeständiger Kupferbeschichtungen auf anorganischen Dielektrika, vorzugsweise auf Keramik-und Emaillesubstraten, durch chemische und galvanische Metallabscheidung.

Verfahren zur Herstellung von Kupferbeschichtungen auf anorganische Dielektrika durch chemische und galvanische Metallabscheidung sind bereits bekannt.

Kupferbeschichtete Basismaterialien auf Basis anorganischer Dielektrika, wie Keramik und emaillierte Metallkerne, dienen zum Aufbau elektronischer Schaltungen und sind vorzugsweise bei solchen Anwendungen eingesetzt, bei denen es auf unter anderem hohe Wärmeleitfähigkeit oder erhöhte Betriebstemperaturen ankommt.

Hochleistungs-Substrate in der Elektronik haben neben der Funktion, sehr hohe Ströme durch die Leiterbahnen fließen zu lassen, auch die Aufgabe, die entstehende Verlustwärme von den aktiven Bauelementen rasch abzeführen. Leistungshalbleiter mit Schaltströmen von einigen 100A müssen zu diesem Zweck auf derartige metallisierte Substrate aufgelötet werden. Mit Kupfer beschichtete Keramiksubstrate oder emaillierte Stahlsubstrate erfüllen diese Anforderungen besser, als die mittels Siebdrucke aufgebrachten und eingebrannten Dickschicht-Leitpasten, da die elektrische und thermische Leitfähigkeit des reinen Kupfers erheblich besser ist.

Nachteilig ist jedoch, daß die Belastbarkeit des Aufbaus: Substrat, chemisch kupfer-galvanisch Kupfer auf Temperaturen bis maximal 290° C begrenzt ist, die außerdem nur kurzfristig eingehalten werden dürfen bis zu 10 Minuten.

Bei noch höheren Temperaturen oder längerer thermischer Belastung führen eingeschlossene Verunreinigungen, wie insbesondere Flüssigkeitsreste, zur Zerstörung des Materialverbundes in Form von Blasenbildung im Metallüberzug.

Aufgabe der vorliegenden Erfindung ist die Bereitstellung eines Verfahrens, welches die Herstellung beständiger Kupferbeschichtungen der eingangs bezeichneten Art auch bei längerer Belastung bei hohen Temperaturen ohne Blasenbildung ermöglicht.

Diese Aufgabe wird erfindungsgemäß durch ein Verfahren gemäß dem kennzeichnenden Teil des Patentanspruchs gelöst.

Die erfindugsgemäß auf Keramik- und Emaillesubstrate aufgebrachten Kupferbeschichtungen sind überraschenderweise bei Temperaturen bis zu 500° C und mehr beständig und zeigen keine Blasenbildung, was technisch insbesondere für ihre Verwendung zum Aufbau von elektronischen Schaltungen von großer Bedeutung ist.

Hier können Sie mit großem Erfolg für Höchstleistungsmodule eingesetzt werden.

Als Substrate kommen handelsübliche Keramiken zum Einsatz wie die verschiedenen Sorten von Alumiumoxidkeramik oder Aluminiumnitridkeramik oder Keramiken wie Berylliumoxidkeramik oder zum Beispiel Bariumtitanat. Diese werden in üblicher Weise vorbehandelt, und mit einer dünnen Metallschicht vorzugsweise Kupfer überzogen. Es ist aber auch Nickel, Kobalt oder Gold als Grundmetallisierung einsetzbar.

Die erfindungsgemäßen Verfahrensschritte der chemischen und galvanischen Kupferabscheidung erfolgen mit den hierfür an sich bekannten Bädern unter den hierfür üblichen Bedingungen.

Die erfindungsgemäße metallische Behandlung der chemischen Kupferschicht kann durch vielerlei Massnahmen erfolgen, die eine Verstopfung der Poren in der Oberfläche dieser Kupferschicht bewirken. Besonders geeignet hierfür ist eine Verdichtung der Oberfläche, wie sie insbesondere durch einen Bürstenvorgang mit nachfolgendem Poliervorgang erreicht wird.

Hierbei wird die Oberfläche zum Beispiel mit einer rotierenden Kupferdrahtbürste zunächst trokken überglänzt, was ein leichtes Polieren und Verschmieren des weichen Materials im gewünschten Ausmass zur Folge hat.

Vorteilhafterweise wird diese Behandlung unter Zusatz von Wasser wiederholt oder alternativ eine Polierung der Oberfläche mit einem geeigneten Mittel angeschlossen.

Hierzu eignen sich zum Beispiel Schlämmkreide. Calcium- und Magnesiumcarbonate sowie auch Glasperlen mit 50 $\mu$m Durchmesser, vorausgesetzt, daß keine scharfkantigen Körper enthalten sind.

Poliert werden kann von Hand oder mittels Maschinen zum Beispiel mit Nylon-Bürsten.

Rasterelektronenmikroskopische Aufnahmen der Oberflächen zeigen, daß die Oberfläche des chemisch abgeschiedenen Kupfers durch das Bürsten eingeebnet wird und schuppenartig aussieht. Aus der lichtmikroskopischen Untersuchung von Querschliffen geht hervor, daß das Metallgefüge durch das Bürsten nur im oberflächennahen Bereich bis zu einer Tiefe zwischen ca. o,5 und 3 $\mu$m beeinflußt wird. Durch das anschließende Polieren werden die Schuppen geglättet, so daß eine nahezu porenfreie Oberfläche entsteht, in die bei der Vorbehandlung und beim Beginn des galvanischen Aufbaus während der üblichen Behandlungszeiten keine wäßrigen Lösungen einzudringen vermögen.

Eine Alternative zum Bürsten und Polieren besteht in einer nicht abrasiven Behandlung mit Strahlmitteln wie Glasperlen oder pflanzlichen Granulaten. Auch Kugelpolieren hat sich als geeignet erwiesen.

Die Tatsache, daß diese so einfache und scheinbar naheliegende Massnahme der mechanischen Behandlung der chemischen Kupferschicht als einer der erfindungsgemäßen Verfahrensschritte derart unerwartete Wirkungen zeigt, spricht für eine besondere erfinderische Tätigkeit.

Die folgenden Beispiele dienen zur Erläuterung der Erfindung.

BEISPIEL 1

Eine mit 10 μm chemisch abgeschiedenem Kupfer beschichtete Platte aus Aluminiumoxidkeramik in Dickschichtqualität wurde bei 323° C unter Schutzgas getempert, mit einer rotierenden Kupferdrahtbürste zunächst trocken, dann naß gebürstet und anschließend wurde eine für die Leistungselektronik typische Struktur mit Metallflächen von mehreren Quadratzentimetern geätzt.

BEISPIEL 2

Eine mit 10 μm chemisch abgeschiedenem Kupfer beschichtete Platte aus Aluminiumoxidkeramik in Dickschichtqualität wurde bei 323° C unter Schutzgas getempert, mit einer rotierenden Kupferdrahtbürste zunächst trocken, dann naß gebürstet und nach zusätzlicher chemischer Abscheidung von 10 mm Kupfer wiederum unter gleichen Bedingungen trocken und naß gebürstet und die gleiche Struktur wie in Beispiel 1 geätzt.

BEISPIEL3

Eine mit 10 μm chemisch abgeschiedenem Kupfer beschichtete Platte aus Aluminiumoxidkeramik in Dickschichtqualität wurde bei 323° C unter Schutzgas getempert, mit einer rotierenden Kupferdrahtbürste zunächst trocken gebürstet und dann von Hand naß mit einem Lappen unter Zuhilfenahme von 50 μm-Glasperlen poliert. Anschließend erfolgte ein zusätzlicher Aufbau von 50 μm galvanisch abgeschiedenem Kupfer. Es wurde die gleiche Struktur wie in Beispiel 1 geätzt.

BEISPIEL 4

Eine mit 10 μm chemisch abgeschiedenem Kupfer beschichtete Platte aus Aluminiumoxidkeramik in Dickschichtqualität wurde bei 323° C unter Schutzgas getempert, mit einer rotierenden Kupferdrahtbürste zunächst trocken gebürstet und dann von Hand naß mit einem Lappen unter Zuhilfenahme von handelsüblicher Zahncreme poliert. Auf der so behandelten Metallisierung wurden 100 μm Kupfer galvanisch abgeschieden und die gleiche Struktur wie in Beispiel 1 geätzt.

BEISPIEL 5

Eine mit 10 μm chemisch abgeschiedenem Kupfer beschichtete Platte aus Aluminiumoxidkeramik in Dickschichtqualität wurde bei 400° C unter Schutzgas getempert, mit einer rotierenden Kupferdrahtbürste zunächst trocken gebürstet und dann von Hand naß mit einem Lappen unter Zuhilfenahme von handelsüblicher Zahncreme poliert. Nach Laminieren, Belichten und Entwickeln eines Photoresists wurden in den freientwickelten Bereichen 40 μm Kupfer, 2 μm Nickel und 1μm Gold abgeschieden. Nach Entfernen des Photoresists wurde die 10 m dicke Haftschichtmetallisierung geätzt.

BEISPIEL 6

Eine mit 10 μm chemisch abgeschiedenem Kupfer beschichtete Platte aus Aluminiumoxidkeramik in Dickschichtqualität wurde bei 400°C unter Schutzgas getempert, mit Nußschalengranulat gestrahlt und anschließend wie in Beispiel 5 strukturiert.

Bewertung der Versuchsergebnisse:

Bei einem Blasentest, bei dem die Substrate der Beispiele 1 bis 6 in ca. 5 min. auf 400°C aufgeheizt wurden, blieben alle Substrate blasenfrei. Gleiche Ergebnisse wurden beim flußmittelfreien Löten unter reduzierenden Bedingungen und Temperaturen zwischen 290 und 410°C erreicht.

Ansprüche

1. Verfahren zur Herstellung hochtemperaturbeständiger Kupferbeschichtungen auf anorganischen Dielektrika, vorzugsweise auf Keramik- und Emailesubstraten, durch chemische und galvanische Metallabscheidung, gekennzeichnet durch folgende Verfahrensschritte:
- Abscheiden einer chemischen Kupferschicht in einer Schichtdicke von minstens 3 μm
- Erhitzen der chemischen Kupferschicht auf Temperaturen>100°C, vorzugsweise auf 200 bis

450° C
- Mechanische Behandlung der chemischen Kupferschicht, vorzugsweise durch Verdichtung der Oberfläche, insbesondere durch Bürsten und Polieren
- Abscheiden einer galvanischen Kupferschicht in einer Schichtdicke von mindestens 3 μm, vorzugsweise von 40 bis 100 μm.

2. Hochtemperaturbeständige Kupferbeschichtungen auf Keramik- und Emaillesubstraten hergestellt gemäß dem Verfahren nach Anspruch 1.

3. Verwendung der hochtemperaturbeständigen Kupferbeschichtungen gemäß Anspruch 2 zum Aufbau von elektronischen Schaltungen.